(19) Europäisches Patentamt
European Patent Office
Office européen des brevets

(11) **EP 2 477 233 A1**

(12) **EUROPEAN PATENT APPLICATION**
published in accordance with Art. 153(4) EPC

(43) Date of publication:
**18.07.2012 Bulletin 2012/29**

(51) Int Cl.:
*H01L 31/075* (2012.01)     *H01L 31/0224* (2006.01)
*C23C 14/08* (2006.01)

(21) Application number: **10815196.0**

(22) Date of filing: **23.06.2010**

(86) International application number:
**PCT/JP2010/060599**

(87) International publication number:
**WO 2011/030598 (17.03.2011 Gazette 2011/11)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **10.09.2009  JP 2009209293**

(71) Applicant: **Mitsubishi Heavy Industries, Ltd.
Tokyo 108-8215 (JP)**

(72) Inventors:
• **YAMAGUCHI, Kengo
Tokyo 108-8215 (JP)**
• **YAMASHITA, Nobuki
Tokyo 108-8215 (JP)**

(74) Representative: **Bongiovanni, Simone et al
Studio Torta S.p.A.
Via Viotti, 9
10121 Torino (IT)**

(54) **PRODUCTION METHOD FOR PHOTOVOLTAIC DEVICE**

(57)     A process for producing a photovoltaic device having high photovoltaic conversion efficiency by suppressing light absorption in the visible light short wavelength region. The process for producing a photovoltaic device (100) comprises a step of forming a substrate-side transparent electrode layer (2) on a substrate (1), a step of forming an intermediate contact layer (5) between two adjacent cell layers (91, 92), and a step of forming a backside transparent electrode layer (6) on a photovoltaic layer (3), wherein a transparent conductive film comprising mainly Ga-doped ZnO is deposited as the substrate-side transparent electrode layer (2), the intermediate contact layer (5) or the backside transparent electrode layer (6), under conditions in which the $N_2$ gas partial pressure is controlled so that the ratio of $N_2$ gas partial pressure relative to inert gas partial pressure per unit thickness of the transparent conductive film is not more than a predetermined value.

FIG. 1

**Description**

Technical Field

The present invention relates to a process for producing a photovoltaic device, and relates particularly to a process for producing a thin-film solar cell in which the electric power generation layer is formed by deposition.

Background Art

One known example of a photovoltaic device used in a solar cell that converts the energy from sunlight into electrical energy is a thin-film silicon-based photovoltaic device comprising a photovoltaic layer formed by using a plasma-enhanced CVD method or the like to deposit thin films of a p-type silicon-based semiconductor (p-layer), an i-type silicon-based semiconductor (i-layer) and an n-type silicon-based semiconductor (n-layer) on top of a transparent electrode layer formed on a substrate.

In order to improve the photovoltaic conversion efficiency, namely the electric power generation output, of thin-film silicon-based solar cells, tandem solar cells have been proposed in which the photovoltaic layer is formed by stacking two stages of electric power generation cell layers having different absorption wavelength bands, thereby enabling more efficient absorption of the incident light. In tandem solar cells, an intermediate contact layer is frequently inserted between the layers of the first electric power generation cell and the layers of the second electric power generation cell that function as the photovoltaic layer, for the purposes of inhibiting the mutual diffusion of dopants between the cell layers and adjusting the light intensity distribution.

Further, in the case of super straight type solar cells where the sunlight enters the cell from the side of the transparent substrate, a transparent electrode layer is frequently interposed between the photovoltaic layer and the back metal electrode in order to reflect the incident light inside the solar cell, thereby lengthening the light path and increasing the amount of light absorbed by the photovoltaic layer.

The above-mentioned substrate-side transparent electrode layer, intermediate contact layer and backside transparent electrode layer are formed, for example, from a thin film of a transparent oxide that exhibits conductivity, such as a GZO (Ga-doped ZnO) film.

It is well known that controlling the oxygen atmosphere during GZO deposition is an important factor in controlling the film quality of the GZO film. GZO films for use in solar cells require good transparency and a high level of conductivity, but these two properties tend to be mutually opposite. Namely, because the conductivity of a GZO film is due to ZnO oxygen loss, the conductivity improves as the oxygen concentration of the deposition atmosphere is lowered. However, increased oxygen loss (carriers) is accompanied by an increase in infrared absorption, and an increase in the absorption of light from the infrared region to the visible region caused by free metallic Zn. Further, impurities (nodules) generated on the target surface during sputtering deposition and metallic impurities from the discharge unit can also cause absorption by the GZO film.

Patent Literature (PTL) 1 discloses a solar cell having a zinc oxide film comprising nitrogen atoms as a dopant at a concentration of not more than 5 atomic%. PTL1 discloses that by providing a zinc oxide film comprising nitrogen atoms at the interface between the electrode and the semiconductor layers, the adhesion between the layers can be improved.

Non Patent Literature (NPL) 1 discloses that during sputtering deposition using a ZnO target, a $Zn_xN_yO_z$ film can be formed by using a mixed atmosphere of Ar and $N_2$, and also discloses that adding nitrogen narrows the band gap.

Citation List

Patent Literature

{PTL 1} Publication of Japanese Patent No. 2,908,617 (claims 1 and 2, paragraphs [0023] to [0029])

Non Patent Literature

{NPL 1} "Optical properties of zinc oxynitride thin films", Masanobu Futsuhara et al., Thin Solid Films, 317 (1998), pp. 322 to 325.

Summary of Invention

Technical Problem

Investigations by the inventors of the present invention revealed that there are cases where absorption by a GZO film occurs only in the visible light short wavelength region, and that the cause of this phenomenon is Zn nitrides generated by nitrogen in the deposition atmosphere. It is thought that the nitrogen within the atmosphere is due to atmospheric nitrogen that has leaked into the deposition chamber. Accordingly, in those cases where a GZO film is used for the substrate-side transparent electrode layer, the intermediate contact layer or the backside transparent electrode layer, the amount of $N_2$ gas within the deposition atmosphere must be controlled in order to reduce absorption by the GZO film.

The present invention provides a process for producing a photovoltaic device having a high photovoltaic conversion efficiency, by inhibiting light absorption in the visible light short wavelength region by the substrate-side transparent electrode layer, the intermediate contact layer and the backside transparent electrode layer.

Solution to Problem

In order to address the problem outlined above, a first aspect of the present invention provides a process for producing a photovoltaic device, wherein at least one step among a step of forming a substrate-side transparent electrode layer on a substrate and a step of forming a backside transparent electrode layer on a photovoltaic layer comprises depositing a transparent conductive film comprising mainly Ga-doped ZnO as the substrate-side transparent electrode layer or the backside transparent electrode layer, under conditions in which the $N_2$ gas partial pressure is controlled so that the ratio of the $N_2$ gas partial pressure relative to the inert gas partial pressure per unit thickness of the transparent conductive film is not more than a predetermined value.

A second aspect of the present invention is a process for producing a photovoltaic device, wherein at least one step among a step of forming a substrate-side transparent electrode layer on a substrate, a step of forming an intermediate contact layer between two adjacent cell layers among a plurality of cell layers that constitute a photovoltaic layer, and a step of forming a backside transparent electrode layer on a photovoltaic layer comprises depositing a transparent conductive film comprising mainly Ga-doped ZnO as the substrate-side transparent electrode layer, the intermediate contact layer or the backside transparent electrode layer, under conditions in which the $N_2$ gas partial pressure is controlled so that the ratio of the $N_2$ gas partial pressure relative to the inert gas partial pressure per unit thickness of the transparent conductive film is not more than a predetermined value.

Investigations conducted by the inventors of the present invention revealed that for GZO films of the same thickness, even if the amount of the dopant ($Ga_2O_3$) within the GZO film is altered, substantially identical adsorption spectra are obtained. Further, as the amount of $N_2$ gas relative to the amount of inert gas during deposition is increased, and as the thickness is increased, the light absorptance in the wavelength region from 450 to 600 nm also increases. Absorption by the GZO film causes a reduction in the short-circuit current of the photovoltaic device. Accordingly, in the present invention, when depositing a GZO film as the substrate-side transparent electrode layer, the intermediate contact layer or the backside transparent electrode layer, the amount of $N_2$ gas permissible within the deposition atmospheric gas is set by prescribing a value for the ratio of the $N_2$ gas partial pressure relative to the inert gas partial pressure (namely, the $N_2$ gas partial pressure ratio) per unit thickness of the GZO film. By prescribing a value for this ratio, light absorption loss within the GZO film can be reduced, and any reduction in the short-circuit current of the photovoltaic device can be suppressed, regardless of the amount of Ga doping. As a result, a photovoltaic device having superior photovoltaic conversion efficiency can be produced. As described above, the amount of $N_2$ gas within the deposition atmosphere and the light absorptance of the GZO film in the wavelength region from 450 to 600 nm are correlated, and therefore the $N_2$ gas partial pressure ratio per unit thickness is preferably determined from the GZO film absorptance.

In the invention described above, the substrate-side transparent electrode layer is preferably deposited under conditions in which the $N_2$ gas partial pressure is controlled so that the ratio of the $N_2$ gas partial pressure relative to the inert gas partial pressure per unit thickness of the substrate-side transparent electrode layer is not more than 0.001 %/nm.

The substrate-side transparent electrode layer is formed with a greater thickness than the intermediate contact layer or the backside transparent electrode layer in order to ensure adequate conductivity. When light enters the device from the substrate side, light from the entire visible light wavelength spectrum enters the substrate-side transparent electrode layer. If the amount of absorption due to nitrogen within the GZO film of the substrate-side transparent electrode layer increases, then light in the visible light short wavelength region is attenuated particularly significantly. As a result, the short-circuit current generated by the photovoltaic layer decreases.

In the present invention, when a GZO film is deposited as the substrate-side transparent electrode layer, the $N_2$ gas

partial pressure ratio per unit thickness is limited to not more than 0.001 %/nm. This reduces light loss within the substrate-side transparent electrode layer, and suppresses any reduction in the short-circuit current of the photovoltaic device. The above $N_2$ gas partial pressure ratio must be set to a lower value than that prescribed for the intermediate contact layer or the backside transparent electrode layer to take into consideration the increased thickness of the substrate-side transparent electrode layer.

In the invention described above, the intermediate contact layer or the backside transparent electrode layer is preferably deposited under conditions in which the $N_2$ gas partial pressure is controlled so that the ratio of the $N_2$ gas partial pressure relative to the inert gas partial pressure per unit thickness of the intermediate contact layer or backside transparent electrode layer is not more than 0.025 %/nm.

For example, in a photovoltaic device in which a GZO film comprising nitrogen is provided as the backside transparent electrode layer, and the photovoltaic layer is formed from amorphous silicon, the majority of light in the wavelength region from 400 to 550 nm is absorbed in the photovoltaic layer. During the process in which light reaching the backside transparent electrode layer is reflected by the back electrode layer and exits from the backside transparent electrode layer, light having a wavelength of 550 to 700 nm is attenuated due to absorption by the backside transparent electrode layer.

Further, in a tandem photovoltaic device in which a GZO film comprising nitrogen is provided as the intermediate contact layer, when light enters the device from the substrate side, the short-circuit current in the backside cell layer is reduced by an amount equivalent to the amount of light attenuation within the intermediate contact layer. Further, in the case of the substrate-side cell layer, the short-circuit current is reduced due to the amount of light absorbed by the intermediate contact layer during the process in which light passes through the intermediate contact layer is reflected off the back electrode layer and once again passes through the intermediate contact layer.

In the present invention, when a GZO film is deposited as the intermediate contact layer or the backside transparent electrode layer, the $N_2$ gas partial pressure ratio per unit thickness is limited to not more than 0.025 %/nm. This reduces light loss within the GZO film, and can suppress any reduction in the short-circuit current of the photovoltaic device.

Advantageous Effects of Invention

According to the present invention, because the process is controlled to lower the amount of $N_2$ gas during GZO deposition, light absorption in the visible light short wavelength region caused by the incorporation of nitrogen atoms within the film can be suppressed. As a result, a photovoltaic device having a high level of photovoltaic conversion efficiency is produced.

Brief Description of Drawings

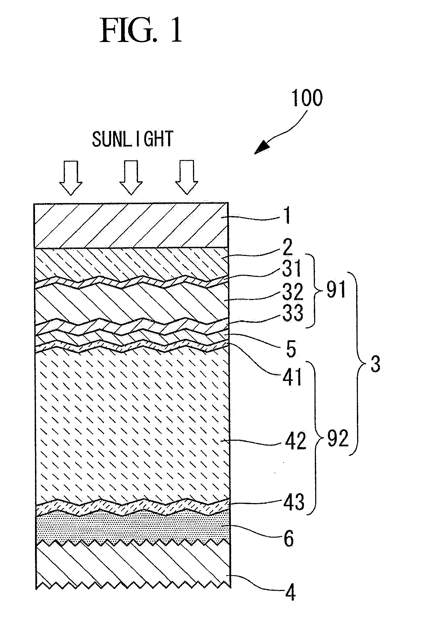

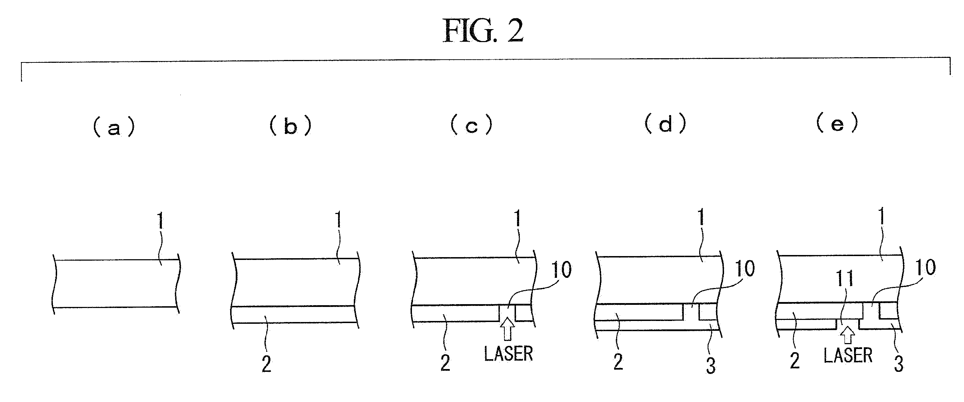

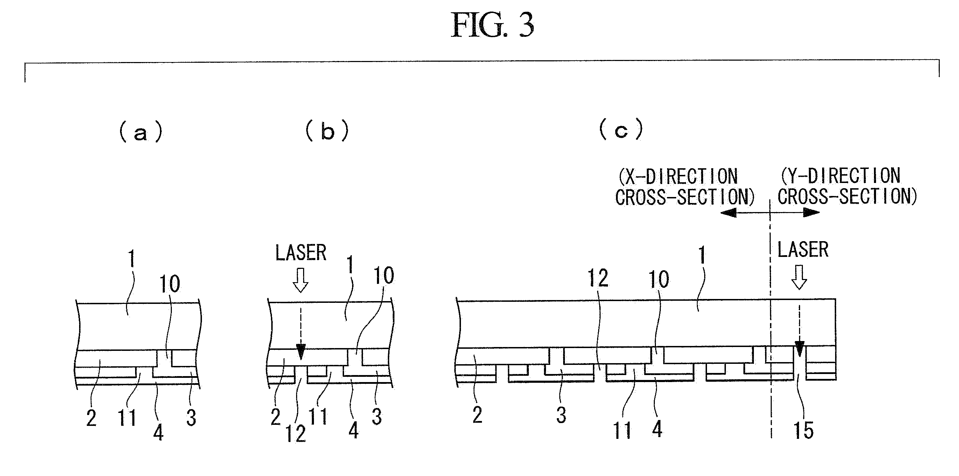

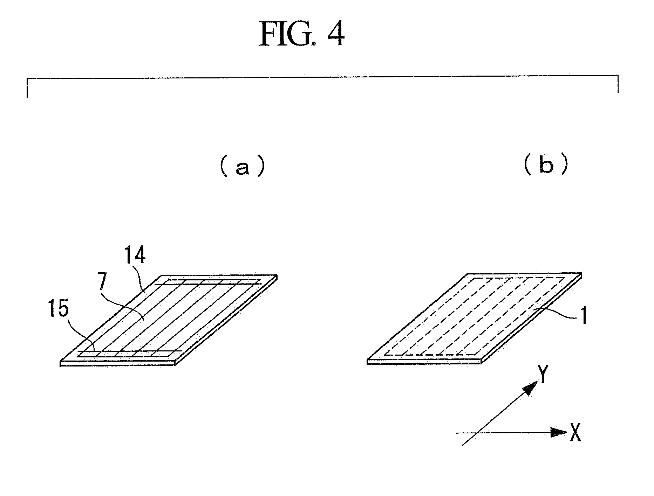

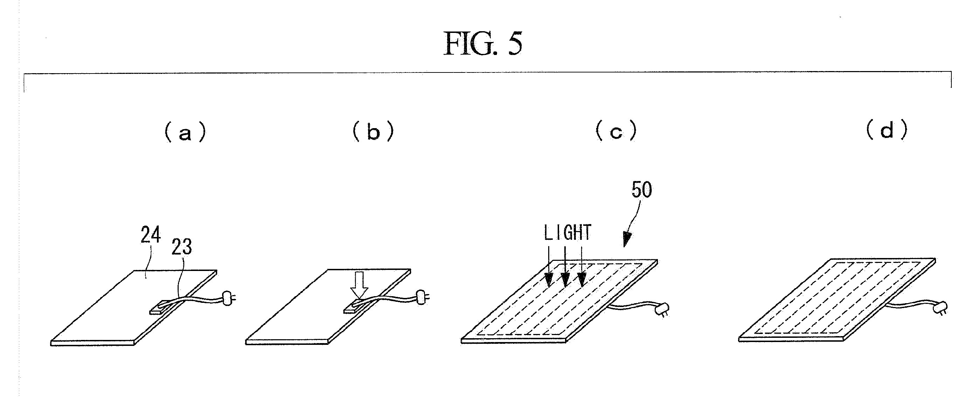

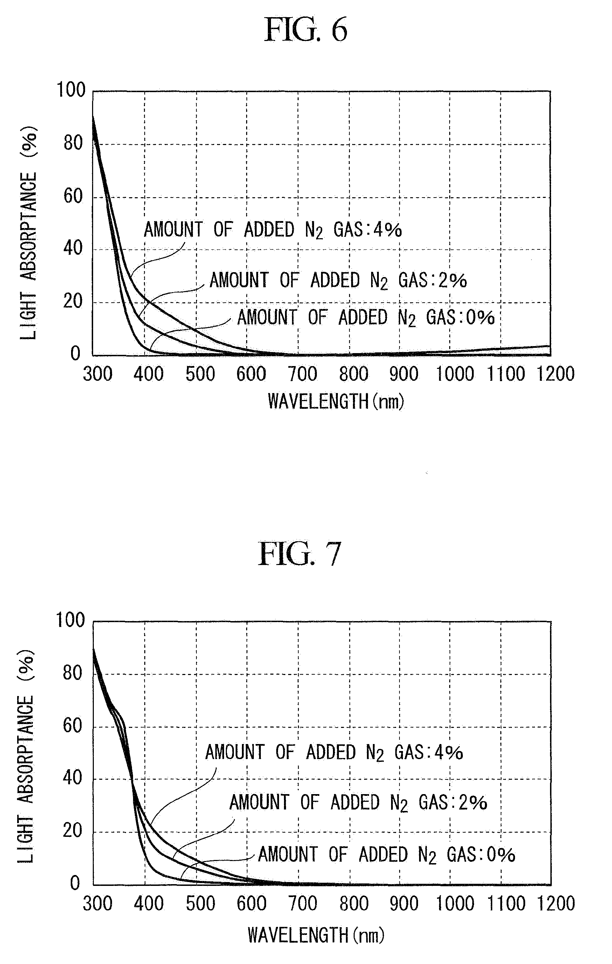

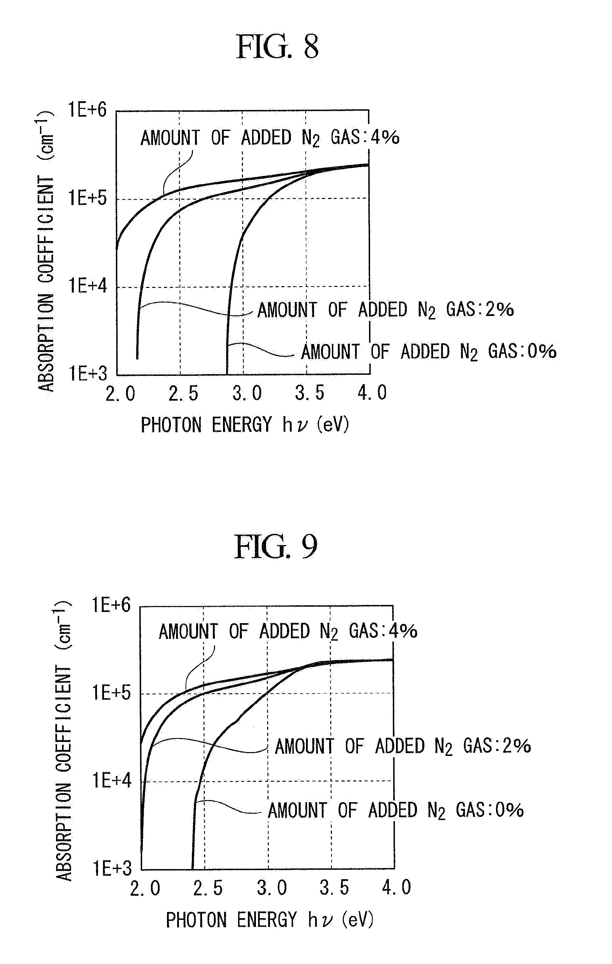

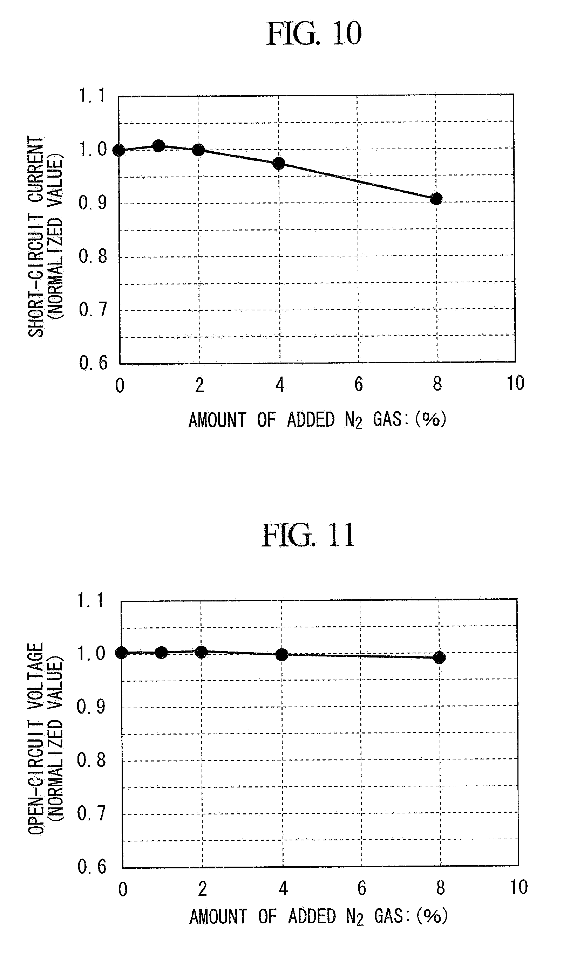

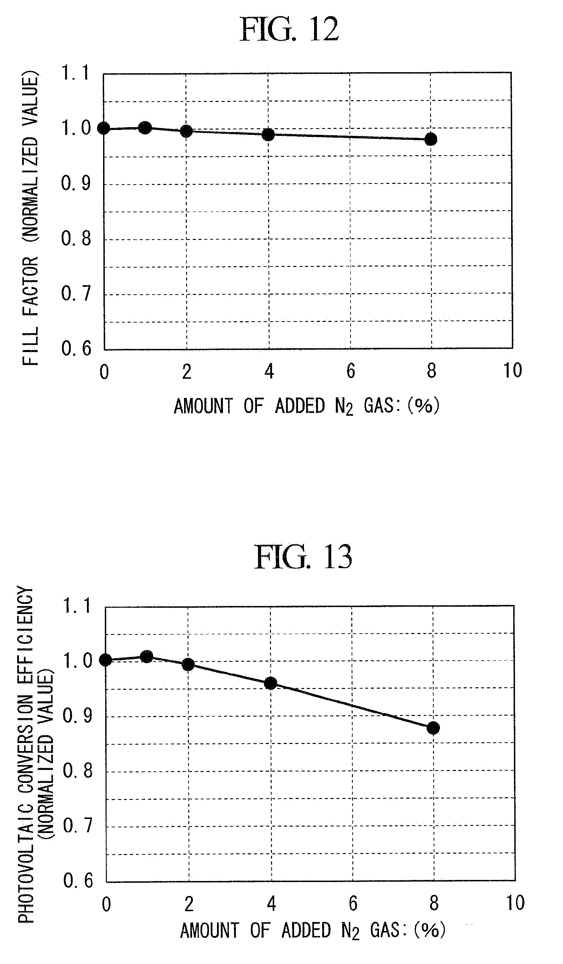

{Fig. 1} A schematic view illustrating the structure of a photovoltaic device produced using a process for producing a photovoltaic device according to the present invention.
{Fig. 2} A schematic illustration describing one embodiment for producing a solar cell panel using a process for producing a photovoltaic device according to the present invention.
{Fig. 3} A schematic illustration describing one embodiment for producing a solar cell panel using a process for producing a photovoltaic device according to the present invention.
{Fig. 4} A schematic illustration describing one embodiment for producing a solar cell panel using a process for producing a photovoltaic device according to the present invention.
{Fig. 5} A schematic illustration describing one embodiment for producing a solar cell panel using a process for producing a photovoltaic device according to the present invention.
{Fig. 6} A diagram illustrating absorption spectra for GZO films in which the amount of $Ga_2O_3$ doping is 5.7 wt%.
{Fig. 7} A diagram illustrating absorption spectra for GZO films in which the amount of $Ga_2O_3$ doping is 0.5 wt%.
{Fig. 8} A diagram illustrating absorption spectra for GZO films in which the amount of $Ga_2O_3$ doping is 5.7 wt%.
{Fig. 9} A diagram illustrating absorption spectra for GZO films in which the amount of $Ga_2O_3$ doping is 0.5 wt%.
{Fig. 10} A graph illustrating the relationship between the short-circuit current and the amount of added $N_2$ gas for a single solar cell unit comprising a GZO film as a backside transparent electrode layer.
{Fig. 11} A graph illustrating the relationship between the open-circuit voltage and the amount of added $N_2$ gas for a single solar cell unit comprising a GZO film as a backside transparent electrode layer.
{Fig. 12} A graph illustrating the relationship between the fill factor and the amount of added $N_2$ gas for a single solar cell unit comprising a GZO film as a backside transparent electrode layer.
{Fig. 13} A graph illustrating the relationship between the photovoltaic conversion efficiency and the amount of added $N_2$ gas for a single solar cell unit comprising a GZO film as a backside transparent electrode layer.

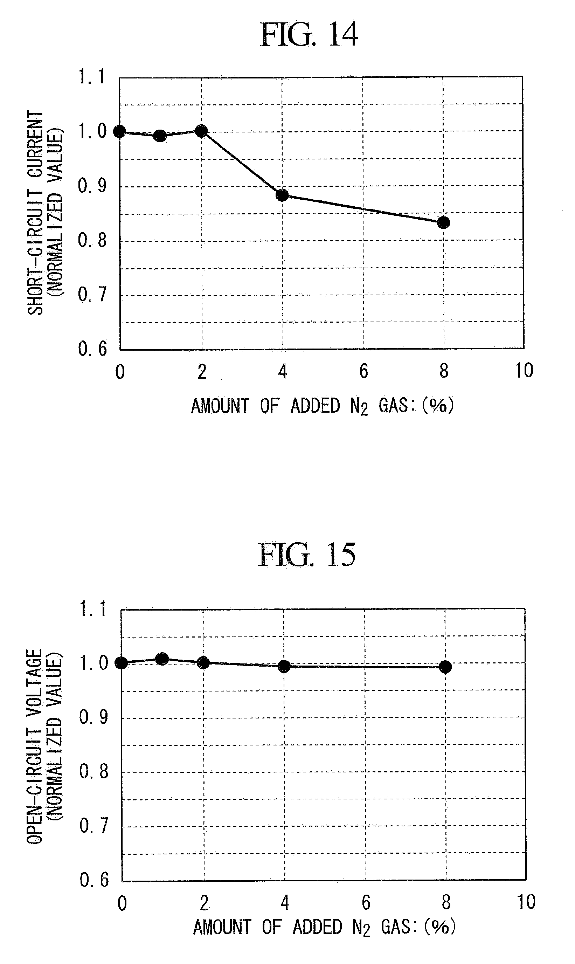

{Fig. 14} A graph illustrating the relationship between the short-circuit current and the amount of added $N_2$ gas for a tandem solar cell unit comprising a GZO film as an intermediate contact layer.

{Fig. 15} A graph illustrating the relationship between the open-circuit voltage and the amount of added $N_2$ gas for a tandem solar cell unit comprising a GZO film as an intermediate contact layer.

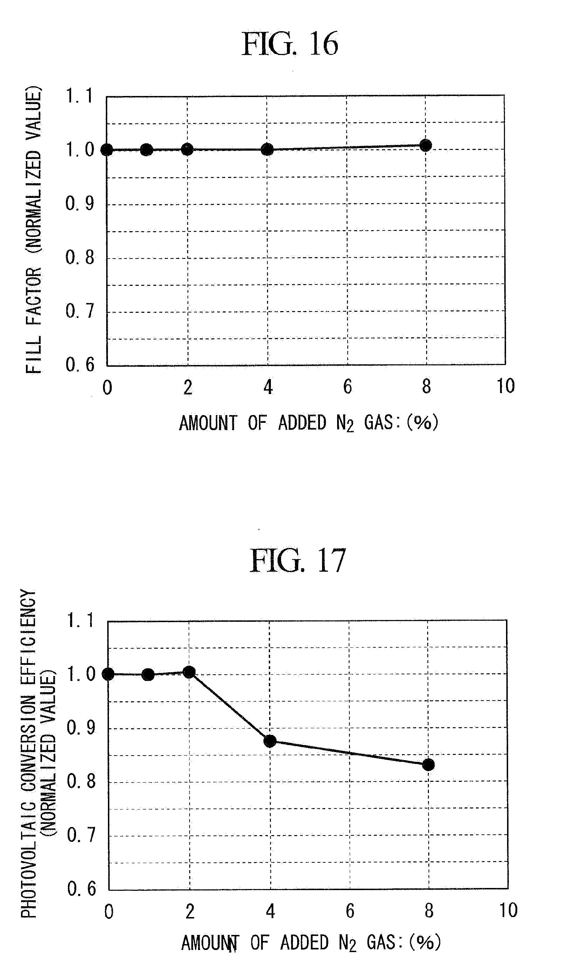

{Fig. 16} A graph illustrating the relationship between the fill factor and the amount of added $N_2$ gas for a tandem solar cell unit comprising a GZO film as an intermediate contact layer.

{Fig. 17} A graph illustrating the relationship between the photovoltaic conversion efficiency and the amount of added $N_2$ gas for a tandem solar cell unit comprising a GZO film as an intermediate contact layer.

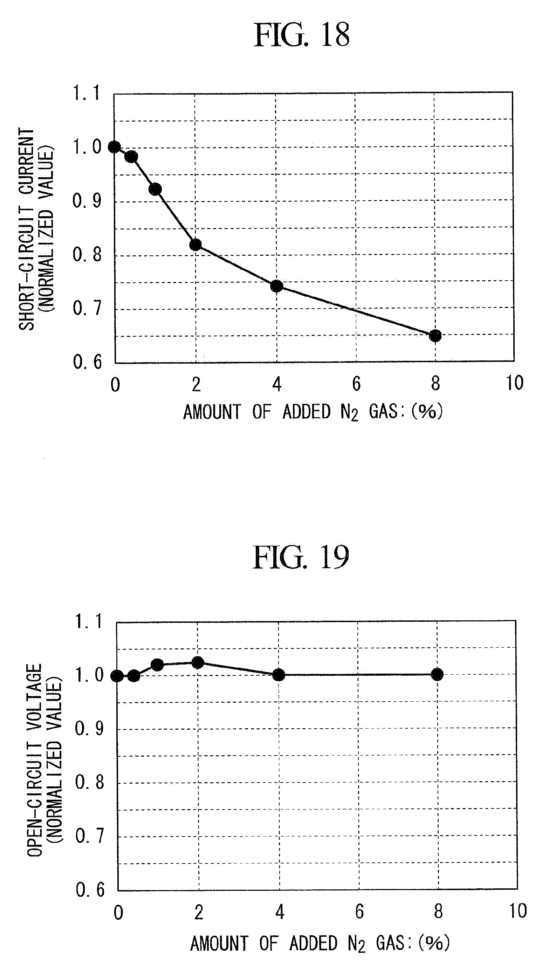

{Fig. 18} A graph illustrating the relationship between the short-circuit current and the amount of added $N_2$ gas for a single solar cell unit comprising a GZO film as a substrate-side transparent electrode layer.

{Fig. 19} A graph illustrating the relationship between the open-circuit voltage and the amount of added $N_2$ gas for a single solar cell unit comprising a GZO film as a substrate-side transparent electrode layer.

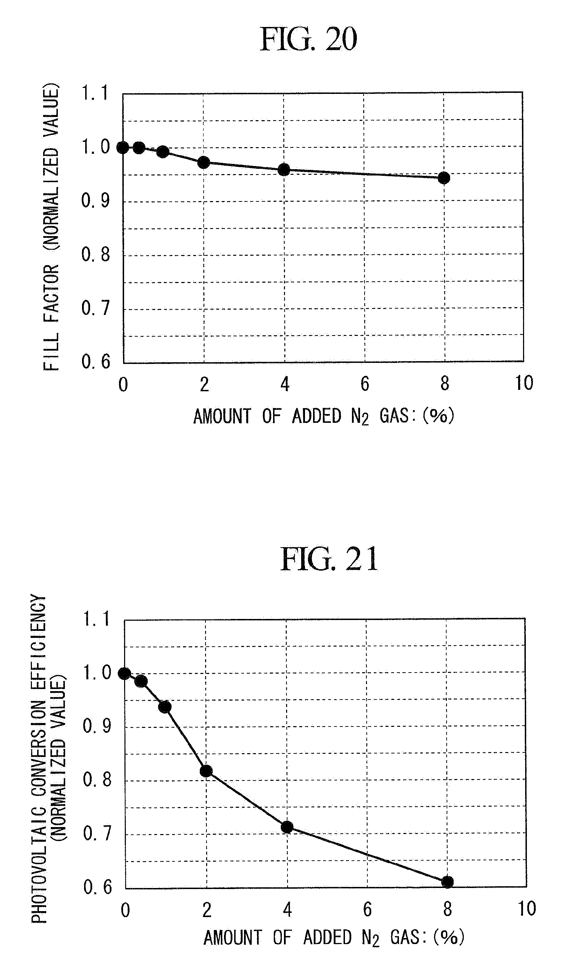

{Fig. 20} A graph illustrating the relationship between the fill factor and the amount of added $N_2$ gas for a single solar cell unit comprising a GZO film as a substrate-side transparent electrode layer.

{Fig. 21} A graph illustrating the relationship between the photovoltaic conversion efficiency and the amount of added $N_2$ gas for a single solar cell unit comprising a GZO film as a substrate-side transparent electrode layer.

Description of Embodiments

Fig. 1 is a schematic view illustrating the structure of a photovoltaic device according to the present invention. A photovoltaic device 100 is a tandem silicon-based solar cell, and comprises a substrate 1, a substrate-side transparent electrode layer 2, a solar cell photovoltaic layer 3 comprising a first cell layer 91 (amorphous silicon-based) and a second cell layer 92 (crystalline silicon-based), an intermediate contact layer 5, a backside transparent electrode layer 6, and a back electrode layer 4. In the present embodiment, at least one of the substrate-side transparent electrode layer 2, the intermediate contact layer 5 and the backside transparent electrode layer 6 is a Ga-doped ZnO (GZO) film. Here, the term "silicon-based" is a generic term that includes silicon (Si), silicon carbide (SiC) and silicon germanium (SiGe). Further, the term "crystalline silicon-based" describes a silicon system other than an amorphous silicon system, and includes both microcrystalline silicon systems and polycrystalline silicon systems.

First embodiment

A process for producing a photovoltaic device according to a first embodiment is described below, using the production steps for a solar cell panel as an example. Fig. 2 to Fig. 5 are schematic views illustrating the process for producing a solar cell panel according to this embodiment.

(1) Fig. 2(a)

A soda float glass substrate (for example with a surface area of at least 1 $m^2$, or specifically, dimensions of 1.4 m × 1.1 m × thickness: 3.5 to 4.5 mm) is used as the substrate 1. The edges of the substrate are preferably subjected to corner chamfering or R-face chamfering to prevent damage caused by thermal stress or impacts or the like.

(2) Fig. 2(b)

Using a DC magnetron sputtering apparatus, a GZO film having a thickness of not less than 400 nm and not more than 1,000 nm is formed as the substrate-side transparent electrode layer 2. The deposition conditions include, for example, a Ga-doped ZnO sintered compact as the target, Ar gas and $O_2$ gas as the introduced gases, a deposition pressure of 0.2 Pa, and a substrate temperature of 120°C. The amount of Ga ($Ga_2O_3$) doping within the target may be set to any arbitrary value, provided favorable conductivity and transparency properties can be achieved for the substrate-side transparent electrode layer. By performing deposition under the conditions mentioned above, a texture having suitable asperity is formed on the surface of the transparent electrode film.

If the ratio of the $N_2$ gas partial pressure relative to the Ar gas partial pressure during GZO deposition is termed the $N_2$ gas partial pressure ratio, then the $N_2$ gas partial pressure during the GZO deposition for the substrate-side transparent electrode layer 2 is controlled so that the $N_2$ gas partial pressure ratio per unit thickness is not more than 0.001 %/nm. The $N_2$ gas partial pressure ratio per unit thickness can be determined, for example, from the light absorptance in the visible light short wavelength region (for example, a wavelength from 450 to 600 nm), using the relationship between the GZO film absorption characteristics and the $N_2$ gas partial pressure ratio at predetermined thickness values.

In one example of a method of ensuring that the $N_2$ gas partial pressure ratio per unit thickness during GZO deposition satisfies the above-mentioned range, the relationship between the ultimate pressure reached during evacuation prior to GZO deposition and the $N_2$ gas partial pressure ratio is determined in advance, and the deposition apparatus is controlled so that evacuation of the deposition chamber is continued until the ultimate pressure that yields the desired $N_2$ gas partial pressure ratio is reached. Further, because the main source of $N_2$ gas incorporation is leakage from the external atmosphere, the $N_2$ gas partial pressure ratio may be controlled by identifying leakage sources using a He leak detector, and ensuring that the leakage rate is not more than a permissible amount relative to the Ar gas flow rate.

The Ar gas partial pressure and the $N_2$ gas partial pressure during GZO deposition may be measured using a mass spectrometer such as Q-mass, with those substrate-side transparent electrode layers that are deposited when the $N_2$ gas partial pressure ratio exceeds a preset value designated as defective items.

In those cases where a GZO film is formed as the intermediate contact layer 5 or the backside transparent electrode layer 6, the substrate-side transparent electrode layer 2 need not necessarily be a GZO film. For example, a transparent conductive film comprising mainly tin oxide ($SnO_2$) and having a film thickness of not less than 500 nm and not more than 800 nm may be deposited as the substrate-side transparent electrode layer 2, using a thermal CVD apparatus at a temperature of approximately 500°C.

In addition to the transparent electrode film, the substrate-side transparent electrode layer 2 may also include an alkali barrier film (not shown in the figure) formed between the substrate 1 and the transparent electrode film. The alkali barrier film is formed using a thermal CVD apparatus at a temperature of approximately 500°C to deposit a silicon oxide film ($SiO_2$) having a film thickness of 50 nm to 150 nm.

(3) Fig. 2(c)

Subsequently, the substrate 1 is mounted on an X-Y table, and the first harmonic of a YAG laser (1064 nm) is irradiated onto the surface of the transparent electrode film, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and conducting laser etching across a strip having a predetermined width of approximately 6 mm to 15 mm to form a slot 10.

(4) Fig. 2(d)

Using a plasma-enhanced CVD apparatus, a p-layer, an i-layer and an n-layer, each composed of a thin film of amorphous silicon, are deposited as the first cell layer 91. Using $SiH_4$ gas and $H_2$ gas as the main raw materials, and under conditions including a reduced pressure atmosphere of not less than 30 Pa and not more than 1,000 Pa and a substrate temperature of approximately 200°C, an amorphous silicon p-layer 31, an amorphous silicon i-layer 32 and an amorphous silicon n-layer 33 are deposited, in that order, on the substrate-side transparent electrode layer 2, with the p-layer closest to the surface from which incident sunlight enters. The amorphous silicon p-layer 31 comprises mainly amorphous B-doped silicon, and has a thickness of not less than 10 nm and not more than 30 nm. The amorphous silicon i-layer 32 has a thickness of not less than 200 nm and not more than 350 nm. The amorphous silicon n-layer 33 comprises mainly P-doped silicon in which microcrystalline silicon is incorporated within amorphous silicon, and has a thickness of not less than 30 nm and not more than 50 nm. A buffer layer may be provided between the amorphous silicon p-layer 31 and the amorphous silicon i-layer 32 in order to improve the interface properties.

The intermediate contact layer 5 that functions as a semi-reflective film for improving the contact properties and achieving electrical current consistency is provided between the first cell layer 91 and the second cell layer 92. Using a DC magnetron sputtering apparatus, a GZO film having a thickness of not less than 20 nm and not more than 100 nm is formed as the intermediate contact layer 5. The amount of Ga doping within the target may be set to any arbitrary value, provided favorable conductivity and transparency properties can be achieved for the intermediate contact layer 5. The deposition conditions may be the same as those used when a GZO film is provided as the substrate-side transparent electrode layer.

In the case of an intermediate contact layer, the $N_2$ gas partial pressure ratio per unit thickness during the deposition is controlled to a value of not more than 0.025 %/nm. The method used for ensuring that the $N_2$ gas partial pressure ratio per unit thickness during GZO deposition satisfies this range may be the same method as that described above for the substrate-side transparent electrode layer 2.

The Ar gas partial pressure and the $N_2$ gas partial pressure during deposition of the intermediate contact layer may be measured using a mass spectrometer, with those intermediate contact layers that are deposited when the $N_2$ gas partial pressure ratio exceeds a preset value designated as defective items.

In those cases where a GZO film is formed as the substrate-side transparent electrode layer 2 or the backside transparent electrode layer 6, the intermediate contact layer 5 may be formed from a different transparent conductive oxide such as F-doped $SnO_2$ or ITO. Further, in some cases, an intermediate contact layer 5 may not be provided.

Next, using a plasma-enhanced CVD apparatus, and under conditions including a reduced pressure atmosphere of not more than 3,000 Pa, a substrate temperature of approximately 200°C and a plasma generation frequency of not less than 40 MHz and not more than 100 MHz, a crystalline silicon p-layer 41, a crystalline silicon i-layer 42 and a crystalline silicon n-layer 43 are deposited sequentially as the second cell layer 92 on top of the first cell layer 91. The crystalline silicon p-layer 41 comprises mainly B-doped microcrystalline silicon, and has a thickness of not less than 10 nm and not more than 50 nm. The crystalline silicon i-layer 42 comprises mainly microcrystalline silicon, and has a thickness of not less than 1.2 $\mu$m and not more than 3.0 $\mu$m. The crystalline silicon n-layer 43 comprises mainly P-doped microcrystalline silicon, and has a thickness of not less than 20 nm and not more than 50 nm.

During formation of the i-layer comprising mainly microcrystalline silicon using a plasma-enhanced CVD method, a distance d between the plasma discharge electrode and the surface of the substrate 1 is preferably not less than 3 mm and not more than 10 mm. If this distance d is less than 3 mm, then the precision of the various structural components within the film deposition chamber required for processing large substrates means that maintaining the distance d at a constant value becomes difficult, which increases the possibility of the electrode getting too close and making the discharge unstable. If the distance d exceeds 10 mm, then achieving a satisfactory deposition rate (of at least 1 nm/s) becomes difficult, and the uniformity of the plasma also deteriorates, causing a deterioration in the quality of the film due to ion impact.

(5) Fig. 2(e)

The substrate 1 is mounted on an X-Y table, and the second harmonic of a laser diode excited YAG laser (532 nm) is irradiated onto the surface of the photovoltaic layer 3, as shown by the arrow in the figure. With the pulse oscillation set to 10 kHz to 20 kHz, the laser power is adjusted so as to achieve a suitable process speed, and laser etching is conducted at a point approximately 100 $\mu$m to 150 $\mu$m to the side of the laser etching line within the substrate-side transparent electrode layer 2, so as to form a slot 11. The laser may also be irradiated from the side of the substrate 1, and in this case, because the high vapor pressure generated by the energy absorbed by the amorphous silicon-based first cell layer of the photovoltaic layer 3 can be utilized in etching the photovoltaic layer 3, more stable laser etching processing can be performed. The position of the laser etching line is determined with due consideration of positioning tolerances, so as not to overlap with the previously formed etching line.

(6) Fig. 3 (a)

The backside transparent electrode layer 6 is provided between the photovoltaic layer 3 and the back electrode layer 4 for the purposes of reducing the contact resistance between the crystalline silicon n-layer 43 and the back electrode layer 4, and improving the reflectance. Using a DC magnetron sputtering apparatus, a GZO film having a thickness of not less than 50 nm and not more than 100 nm is formed as the backside transparent electrode layer 6. In a similar manner to that mentioned above, the amount of Ga doping within the target may be set to any arbitrary value, provided favorable conductivity and transparency properties can be achieved for the backside transparent electrode layer. The deposition conditions may be the same as those used when a GZO film is provided as the substrate-side transparent electrode layer.

In a similar manner to that described for the intermediate contact layer 5, the $N_2$ gas partial pressure ratio during deposition of the GZO film for the backside transparent electrode layer 6 is controlled so that the $N_2$ gas partial pressure ratio per unit thickness is not more than 0.025 %/nm. The method used for ensuring that the $N_2$ gas partial pressure ratio per unit thickness during GZO deposition satisfies this range may be the same method as that described above for the substrate-side transparent electrode layer 2. Further, the Ar gas partial pressure and the $N_2$ gas partial pressure during the GZO deposition may be measured using a mass spectrometer, with those backside transparent electrode layers that are deposited when the $N_2$ gas partial pressure ratio exceeds a preset value designated as defective items.

In those cases where a GZO film is formed as the substrate-side transparent electrode layer 2 or the intermediate contact layer 5, the backside transparent electrode layer 6 may be formed from a different transparent conductive oxide. Further, in some cases, the backside transparent electrode layer 6 may not be provided.

Using a sputtering apparatus, an Ag film and a Ti film are deposited as the back electrode layer 4, under a reduced pressure atmosphere and at a deposition temperature of approximately 150°C to 200°C. In the present embodiment, an Ag film having a thickness of not less than 150 nm and not more than 500 nm, and a highly corrosion-resistant Ti film having a thickness of not less than 10 nm and not more than 20 nm which acts as a protective film for the Ag film are stacked in that order. Alternatively, the back electrode layer 4 may be formed as a stacked structure composed of a Ag film having a thickness of 25 nm to 100 nm, and an Al film having a thickness of 15 nm to 500 nm.

(7) Fig. 3 (b)

The substrate 1 is mounted on an X-Y table, and the second harmonic of a laser diode excited YAG laser (532 nm) is irradiated through the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 $\mu$m to 400 $\mu$m to the side of the laser etching line within the substrate-side transparent electrode layer 2, so as to form a slot 12.

(8) Fig. 3 (c) and Fig. 4 (a)

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated through the substrate 1. The laser light is absorbed by the substrate-side transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the substrate-side transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in Fig. 3(c). Fig. 3 (c) represents an X-direction cross-sectional view cut along the direction of the series connection of the photovoltaic layer 3, and therefore the location in the figure where the insulation slot 15 is formed should actually appear as a peripheral film removed region 14 in which the back electrode layer 4, the photovoltaic layer 3 and the substrate-side transparent electrode layer 2 have been removed by film polishing (see Fig. 4(a)), but in order to facilitate description of the processing of the edges of the substrate 1, this location in the figure represents a Y-direction cross-sectional view, so that the formed insulation slot represents an X-direction insulation slot 15. A Y-direction insulation slot need not be provided at this point, because a film surface polishing and removal treatment is conducted on the peripheral film removal regions of the substrate 1 in a later step.

Completing the etching of the insulation slot 15 at a position 5 mm to 15 mm from the edge of the substrate 1 is preferred, as it ensures that the insulation slot 15 is effective in inhibiting external moisture from entering the interior of the solar cell module 7 via the edges of the solar cell panel.

Although the laser light used in the steps until this point has been specified as YAG laser light, light from a YVO4 laser or fiber laser or the like may also be used in a similar manner.

(9) Fig. 4 (a: view from solar cell film surface side, b: view from substrate side of light incident surface)

In order to ensure favorable adhesion and sealing of a backing sheet 24 via EVA or the like in a subsequent step, the stacked films around the periphery of the substrate 1 (in a peripheral film removal region 14), which tend to be uneven and prone to peeling, are removed to form a peripheral film removed region 14. During removal of the films from a region that is 5 to 20 mm from the edge around the entire periphery of the substrate 1, grinding or blast polishing or the like is used to remove the back electrode layer 4, the photovoltaic layer 3 and the substrate-side transparent electrode layer 2 from a region that is closer to the substrate edge in the X direction than the insulation slot 15 provided in the above step of Fig. 3(c), and closer to the substrate edge in the Y direction than the slot 10 provided near the substrate edge. Grinding debris or abrasive grains are removed by washing the substrate 1.

(10) Fig. 5 (a) (b)

An attachment portion for a terminal box 23 is prepared by providing an open through-window in the backing sheet 24 to expose a collecting plate. A plurality of layers of an insulating material are provided in this open through-window portion in order to prevent external moisture and the like entering the solar cell module.

Processing is conducted so as to enable current collection, using a copper foil, from the series-connected solar cell electric power generation cell at one end, and the solar cell electric power generation cell at the other end, in order to enable electric power to be extracted from the terminal box 23 on the back surface of the solar cell panel. In order to prevent short circuits between the copper foil and the various portions, an insulating sheet that is wider than the width of the copper foil is provided.

Following arrangement of the collecting copper foil and the like at predetermined positions, the entire solar cell module 7 is covered with a sheet of an adhesive filling material such as EVA (ethylene-vinyl acetate copolymer), which is arranged so as not to protrude beyond the substrate 1.

A backing sheet 24 with a superior waterproofing effect is then positioned on top of the EVA. In this embodiment, in order to achieve a superior waterproofing and moisture-proofing effect, the backing sheet 24 is formed as a three-layer structure comprising a PET sheet, an Al foil and a PET sheet.

The structure comprising the components up to and including the backing sheet 24 arranged in predetermined positions is subjected to internal degassing under a reduced pressure atmosphere and under pressing at approximately 150°C to 160°C using a laminator, thereby causing cross-linking of the EVA that tightly seals the structure.

(11) Fig. 5(a)

The terminal box 23 is attached to the back of the solar cell module 7 using an adhesive.

(12) Fig. 5 (b)

The copper foil and an output cable from the terminal box 23 are connected using solder or the like, and the interior of the terminal box 23 is filled and sealed with a sealant (a potting material). This completes the production of the solar cell panel 50.

(13) Fig. 5 (c)

The solar cell panel 50 formed via the steps up to and including Fig. 5(b) is then subjected to an electric power generation test, as well as other tests for evaluating specific performance factors. The electric power generation test is conducted using a solar simulator that emits a standard sunlight of AM 1.5 (1,000 W/$m^2$).

(14) Fig. 5(d)

In tandem with the electric power generation test (Fig. 5(c)), a variety of specific performance factors including the external appearance are evaluated.

Although a tandem solar cell was described as the solar cell in the above embodiment, the present invention is not restricted to this example, and can be similarly applied to other types of thin-film solar cells such as amorphous silicon solar cells, crystalline silicon solar cells containing microcrystalline silicon or the like, silicon-germanium solar cells, and triple solar cells.

Light absorptance of GZO film upon variation in dopant composition

Using either a 5.7 wt% $Ga_2O_3$-ZnO target or a 0.5 wt% $Ga_2O_3$-ZnO target, a DC magnetron sputtering apparatus was used to deposit a GZO film on a glass substrate. The deposition conditions included an ultimate pressure prior to deposition of not more than $1 \times 10^{-4}$ Pa, Ar gas, $O_2$ gas (0.15 sccm) and $N_2$ gas as deposition gases, an amount of added $N_2$ gas relative to the amount of Ar gas (namely, the $N_2$ gas partial pressure ratio) of 0 to 4%, a deposition pressure of 0.2 Pa, a substrate temperature of 120°C, a target-substrate separation distance of 90 mm, and a targeted film thickness of 80 nm. The $N_2$ gas partial pressure ratio was determined from the Ar gas flow rate and the $N_2$ gas flow rate.

The transmittance and reflectance of each GZO film was measured for wavelengths from 300 to 1200 nm, and the light absorptance was calculated as 100 - transmittance - reflectance (%). Fig. 6 and Fig. 7 illustrate absorption spectra for GZO films in which the amount of $Ga_2O_3$ doping is 5.7 wt% and 0.5 wt% respectively. In these figures, the horizontal axis represents the wavelength, and the vertical axis represents the light absorptance.

Fig. 8 and Fig. 9 show the absorption spectra of Fig. 6 and Fig. 7 respectively displayed in terms of the photon energy and the absorption coefficient. In these figures, the horizontal axis represents the photon energy and the vertical axis represents the absorption coefficient.

In the wavelength region of 400 nm and below, an increase in the amount of $Ga_2O_3$ causes a shift in the GZO absorption edge to a shorter wavelength. In the wavelength region from 450 nm (2.76 eV) to 600 nm (2.07 eV), the light absorptance and the absorption coefficient increased with increasing $N_2$ gas partial pressure ratio, but were substantially the same for those films that differed only in terms of the 10-fold difference in the amount of added $Ga_2O_3$. This result indicates that absorption in the wavelength region from 450 to 600 nm is due to nitrogen incorporation within the GZO film.

Relationship between $N_2$ gas partial pressure ratio during GZO deposition and solar cell performance

Backside transparent electrode layer

Single amorphous silicon solar cell units were prepared using a variety of different $N_2$ gas partial pressure

ratios during deposition of a GZO film as the backside transparent electrode layer, and the cell performance of these single amorphous silicon solar cell units was evaluated.

Using a glass substrate having dimensions of 1.4 m × 1.1 m, single amorphous silicon solar cell units were prepared with the layer structure listed below. During deposition of the GZO film for the backside transparent electrode layer, the amount of added $N_2$ gas relative to Ar gas (the $N_2$ gas partial pressure ratio) was set to 0%, 1%, 2%, 4% or 8%. The remaining deposition conditions were the same as those mentioned above in the test used for confirming the light absorption coefficient of the GZO film.

Substrate-side transparent electrode layer: $SnO_2$ film, average thickness: 400 nm

Amorphous silicon p-layer: thickness 100 nm

Amorphous silicon i-layer: thickness 200 nm

Crystalline silicon n-layer: thickness 30 nm

Backside transparent electrode layer: GZO film ($Ga_2O_3$ 0.5 wt%), thickness: 80 nm

Back electrode layer: Ag film, thickness: 250 nm

Fig. 10 to Fig. 13 illustrate the relationships between various cell properties of the single solar cell unit having a GZO film as the backside transparent electrode layer, and the amount of added $N_2$ gas during the GZO deposition. In each of these figures, the horizontal axis represents the amount of added $N_2$ gas. The vertical axis represents the short-circuit current in Fig. 10, the open-circuit voltage in Fig. 11, the fill factor in Fig. 12, and the photovoltaic conversion efficiency in Fig. 13. Each graph was normalized against a value of 1 when the amount of added $N_2$ gas was 0%.

As the amount of added $N_2$ gas during GZO deposition was increased, the short-circuit current and the photovoltaic conversion efficiency decreased. In contrast, the open-circuit voltage and the fill factor were independent of the amount of added $N_2$ gas. Reduction in the photovoltaic conversion efficiency of a solar cell unit due to nitrogen incorporation in the GZO film can be permitted up to 5%. Accordingly, in the case where a GZO film is deposited as the backside transparent electrode layer, the amount of added $N_2$ gas must be controlled to a level of not more than 2%.

Reference to Fig. 6 and Fig. 7 reveals that in the case of a GZO film thickness of 80 nm and an amount of added $N_2$ gas of not more than 2%, a light absorptance of not more than 20% can be achieved in the wavelength region from 450 to 600 nm regardless of the amount of the dopant. By using this relationship between the light absorptance of the GZO film and the amount of added $N_2$ gas, an ideal value for the amount of added $N_2$ gas (the $N_2$ gas partial pressure ratio) can be determined from the GZO film light absorptance.

The optical loss A within a GZO film comprising nitrogen can be represented by formula (1) below.

$$A = I_0 \times \{1 - \exp(-\alpha d)\} \qquad (1)$$

($I_0$: incident light intensity, $\alpha$: absorption coefficient, d: GZO film thickness)
When $\alpha d \leq 0.2$, namely when the light absorptance is not more than 20%, $1 - \exp(-\alpha d) \approx \alpha d$, and therefore the optical loss A is represented by formula (2) below.

$$A \approx I_0 \times \alpha d \qquad (2)$$

Because the short-circuit current decreases by an amount equivalent to the optical loss, the reduction in the short-circuit current is proportional to the GZO film thickness. Accordingly, when a GZO film is deposited as the backside transparent electrode layer, the $N_2$ gas partial pressure ratio per unit thickness is set to not more than 2%/80 nm = 0.025 %/nm. The same test was repeated with the thickness of the backside transparent electrode layer varied from 50 nm to 100 nm, and these tests confirmed that reductions in the short-circuit current and the photovoltaic conversion efficiency could be suppressed at $N_2$ gas partial pressure ratios of not more than 0.025 %/nm.

Intermediate contact layer

Tandem silicon solar cells were prepared using a variety of different $N_2$ gas partial pressure ratios during deposition of a GZO film as the intermediate contact layer, and the cell performance of these tandem silicon solar cell units was evaluated.

Using a glass substrate having dimensions of 1.4 m × 1.1 m, tandem silicon solar cell units were prepared with the layer structure listed below. During deposition of the GZO film for the intermediate contact layer, the amount of added $N_2$ gas relative to Ar gas (the $N_2$ gas partial pressure ratio) was set to 0%, 1%, 2%, 4% or 8%. The remaining GZO deposition conditions were the same as those mentioned above in the test used for confirming the light absorption coefficient of the GZO film.

Substrate-side transparent electrode layer: $SnO_2$ film, average thickness: 400 nm

Amorphous silicon p-layer: thickness 10 nm

Amorphous silicon i-layer: thickness 200 nm

Crystalline silicon n-layer: thickness 30 nm

Intermediate contact layer: GZO film ($Ga_2O_3$, 0.5 wt%), thickness: 80 nm

Crystalline silicon p-layer: thickness 20 nm

Crystalline silicon i-layer: thickness 2000 nm

Crystalline silicon n-layer: thickness 30 nm

Backside transparent electrode layer: GZO film ($Ga_2O_3$ 0.5 wt%, amount of added $N_2$ gas: 0%), thickness: 80 nm

Back electrode layer: Ag film, thickness: 250 nm

Fig. 14 to Fig. 17 illustrate the relationships between various cell properties of the tandem solar cell unit having a GZO film as the intermediate contact layer, and the amount of added $N_2$ gas during the GZO deposition. In each of these figures, the horizontal axis represents the amount of added $N_2$ gas. The vertical axis represents the short-circuit current in Fig. 14, the open-circuit voltage in Fig. 15, the fill factor in Fig. 16, and the photovoltaic conversion efficiency in Fig. 17. Each graph was normalized against a value of 1 when the amount of added $N_2$ gas was 0%.

As the amount of added $N_2$ gas during GZO deposition was increased, the short-circuit current and the photovoltaic conversion efficiency decreased. In contrast, the open-circuit voltage and the fill factor were independent of the amount of added $N_2$ gas. Reduction in the photovoltaic conversion efficiency of a solar cell unit due to nitrogen incorporation in the GZO film can be permitted up to 5%. Accordingly, in the case where a GZO film is deposited as the intermediate contact layer, the amount of added $N_2$ gas must be controlled to a level of not more than 2%.

As mentioned above, because the short-circuit current is proportional to the thickness of the nitrogen-containing GZO film, when a GZO film is deposited as the intermediate contact layer, the $N_2$ gas partial pressure ratio per unit thickness is set to not more than 0.025 %/nm.

When the thickness of the intermediate contact layer was varied from 20 nm to 100 nm, reductions in the short-circuit current and the photovoltaic conversion efficiency were able to be suppressed at $N_2$ gas partial pressure ratios of not more than 0.025 %/nm.

Substrate-side transparent electrode layer

Single crystalline silicon solar cell units were prepared using a variety of different $N_2$ gas partial pressure ratios during deposition of a GZO film as the substrate-side transparent electrode layer, and the cell performance of these single crystalline silicon solar cell units was evaluated.

Using a glass substrate having dimensions of 1.4 m $\times$ 1.1 m, single crystalline silicon solar cell units were prepared with the layer structure listed below.

Substrate-side transparent electrode layer: ($Ga_2O_3$ 0.5 wt%), average thickness: 400 nm

Crystalline silicon p-layer: thickness 20 nm

Crystalline silicon i-layer: thickness 2000 nm

Crystalline silicon n-layer: thickness 30 nm

Backside transparent electrode layer: GZO film ($Ga_2O_3$ 0.5 wt%, amount of added $N_2$ gas: 0%), thickness: 80 nm

Back electrode layer: Ag film, thickness: 250 nm

During deposition of the GZO film for the substrate-side transparent electrode layer, the amount of added $N_2$ gas relative to Ar gas (the $N_2$ gas partial pressure ratio) was set to 0%, 0.4%, 1%, 2%, 4% or 8%. The remaining deposition conditions were the same as those mentioned above in the test used for confirming the light absorption coefficient of the GZO film.

Fig. 18 to Fig. 21 illustrate the relationships between various cell properties of the single solar cell unit having a GZO film as the substrate-side transparent electrode layer, and the amount of added $N_2$ gas during the GZO deposition. In each of these figures, the horizontal axis represents the amount of added $N_2$ gas. The vertical axis represents the short-circuit current in Fig. 18, the open-circuit voltage in Fig. 19, the fill factor in Fig. 20, and the photovoltaic conversion efficiency in Fig. 21. Each graph was normalized against a value of 1 when the amount of added $N_2$ gas was 0%.

As the amount of added $N_2$ gas during GZO deposition was increased, the short-circuit current and the photovoltaic conversion efficiency decreased. In contrast, the open-circuit voltage and the fill factor were independent of the amount of added $N_2$ gas. Reduction in the photovoltaic conversion efficiency of a solar cell unit due to nitrogen incorporation in the GZO film can be permitted up to 5%. Accordingly, in the case where a GZO film is deposited as the substrate-side transparent electrode layer, the amount of added $N_2$ gas must be controlled to a level of not more than 0.4%. In other words, when a GZO film is deposited as the substrate-side transparent electrode layer, the $N_2$ gas partial pressure ratio per unit thickness is set to not more than 0.4%/400 nm = 0.001 %/nm. Because the substrate-side transparent electrode layer is positioned on the incident light side of the photovoltaic layer and is formed as a thick film, the light absorptance of the GZO film of the substrate-side transparent electrode layer must be set to a smaller value than that of the intermediate contact layer or the backside transparent electrode layer. Thus, the required GZO film light absorptance may be set appropriately in accordance with the position of the GZO film within the solar cell, with the $N_2$ gas partial pressure ratio then determined accordingly.

When the thickness of the substrate-side transparent electrode layer was varied from 400 nm to 1000 nm, reductions in the short-circuit current and the photovoltaic conversion efficiency were able to be suppressed at $N_2$ gas partial pressure ratios of not more than 0.001 %/nm.

Reference Signs List

| | |
|---|---|
| 1 | Substrate |
| 2 | Substrate-side transparent electrode layer |
| 3 | Photovoltaic layer |
| 4 | Back electrode layer |
| 5 | Intermediate contact layer |
| 6 | Backside transparent electrode layer |
| 7 | Solar cell module |
| 31 | Amorphous silicon p-layer |
| 32 | Amorphous silicon i-layer |
| 33 | Amorphous silicon n-layer |
| 41 | Crystalline silicon p-layer |
| 42 | Crystalline silicon i-layer |
| 43 | Crystalline silicon n-layer |
| 91 | First cell layer |
| 92 | Second cell layer |
| 100 | Photovoltaic device |

**Claims**

1. A process for producing a photovoltaic device, wherein at least one step among a step of forming a substrate-side transparent electrode layer on a substrate, and a step of forming a backside transparent electrode layer on a photovoltaic layer comprises:

   depositing a transparent conductive film comprising mainly Ga-doped ZnO as the substrate-side transparent electrode layer or the backside transparent electrode layer, under conditions in which $N_2$ gas partial pressure is controlled so that a ratio of $N_2$ gas partial pressure relative to inert gas partial pressure per unit thickness of the transparent conductive film is not more than a predetermined value.

2. A process for producing a photovoltaic device, wherein at least one step among a step of forming a substrate-side transparent electrode layer on a substrate, a step of forming an intermediate contact layer between two adjacent cell layers among a plurality of cell layers that constitute a photovoltaic layer, and a step of forming a backside transparent electrode layer on a photovoltaic layer comprises:

   depositing a transparent conductive film comprising mainly Ga-doped ZnO as the substrate-side transparent electrode layer, the intermediate contact layer or the backside transparent electrode layer, under conditions in which $N_2$ gas partial pressure is controlled so that a ratio of $N_2$ gas partial pressure relative to inert gas partial pressure per unit thickness of the transparent conductive film is not more than a predetermined value.

3. The process for producing a photovoltaic device according to claim 2, wherein the intermediate contact layer is deposited under conditions in which $N_2$ gas partial pressure is controlled so that a ratio of $N_2$ gas partial pressure relative to inert gas partial pressure per unit thickness of the intermediate contact layer is not more than 0.025 %/nm.

4. The process for producing a photovoltaic device according to any one of claims 1 to 3, wherein the substrate-side transparent electrode layer is deposited under conditions in which $N_2$ gas partial pressure is controlled so that a ratio of $N_2$ gas partial pressure relative to inert gas partial pressure per unit thickness of the substrate-side transparent electrode layer is not more than 0.001 %/nm.

5. The process for producing a photovoltaic device according to any one of claims 1 to 4, wherein the backside transparent electrode layer is deposited under conditions in which $N_2$ gas partial pressure is controlled so that a ratio of $N_2$ gas partial pressure relative to inert gas partial pressure per unit thickness of the backside transparent electrode layer is not more than 0.025 %/nm.

# FIG. 1

100

SUNLIGHT

EP 2 477 233 A1

FIG. 2

( a )

1

( b )

2
1

( c )

2
10
1
LASER

( d )

3
2
10
1

( e )

3
LASER
2
11
10
1

# FIG. 3

(a)    (b)    (c)

(X-DIRECTION
CROSS-SECTION)    (Y-DIRECTION
CROSS-SECTION)

LASER    LASER

EP 2 477 233 A1

# FIG. 4

( a )

( b )

# FIG. 5

EP 2 477 233 A1

( a )  ( b )  ( c )  ( d )

24  23

LIGHT  50

# FIG. 6

# FIG. 7

# FIG. 8

# FIG. 9

# FIG. 10

# FIG. 11

## FIG. 12

## FIG. 13

## FIG. 14

## FIG. 15

# FIG. 16

# FIG. 17

## FIG. 18

## FIG. 19

# FIG. 20

(Plot: FILL FACTOR (NORMALIZED VALUE) vs AMOUNT OF ADDED N₂ GAS: (%))

# FIG. 21

(Plot: PHOTOVOLTAIC CONVERSION EFFICIENCY (NORMALIZED VALUE) vs AMOUNT OF ADDED N₂ GAS: (%))

## INTERNATIONAL SEARCH REPORT

| International application No. |
|---|
| PCT/JP2010/060599 |

| A. CLASSIFICATION OF SUBJECT MATTER |
|---|
| *H01L31/075*(2006.01)i, *H01L31/0224*(2006.01)i, *C23C14/08*(2006.01)i |

According to International Patent Classification (IPC) or to both national classification and IPC

| B. FIELDS SEARCHED |
|---|

Minimum documentation searched (classification system followed by classification symbols)
H01L31, C23C14

Documentation searched other than minimum documentation to the extent that such documents are included in the fields searched

| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| X | JP 2007-258537 A (Mitsubishi Heavy Industries, Ltd.), 04 October 2007 (04.10.2007), (Family: none) | 1-5 |
| X | JP 2009-135220 A (Mitsubishi Heavy Industries, Ltd.), 18 June 2009 (18.06.2009), (Family: none) | 1-5 |
| A | JP 2009-57605 A (Hitachi, Ltd.), 19 March 2009 (19.03.2009), & US 2009/0057132 A1 | 1-5 |

☐ Further documents are listed in the continuation of Box C.  ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 16 July, 2010 (16.07.10) | 17 August, 2010 (17.08.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2908617 B


**Non-patent literature cited in the description**

- **MASANOBU FUTSUHARA et al.** Optical properties of zinc oxynitride thin films. *Thin Solid Films,* 1998, vol. 317, 322-325